(19) Europäisches Patentamt
European Patent Office
Office européen des brevets

(11) **EP 4 060 892 A1**

(12) **EUROPEAN PATENT APPLICATION**
published in accordance with Art. 153(4) EPC

(43) Date of publication:
**21.09.2022  Bulletin 2022/38**

(21) Application number: **19952689.8**

(22) Date of filing: **12.11.2019**

(51) International Patent Classification (IPC):
***H02P 25/03*** *(2016.01)*

(52) Cooperative Patent Classification (CPC):
**H02P 25/03**

(86) International application number:
**PCT/JP2019/044232**

(87) International publication number:
**WO 2021/095109 (20.05.2021 Gazette 2021/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **MITSUBISHI ELECTRIC
CORPORATION
Chiyoda-ku
Tokyo 100-8310 (JP)**

(72) Inventor: **FURUKAWA, Akira
Tokyo 100-8310 (JP)**

(74) Representative: **Hoffmann Eitle
Patent- und Rechtsanwälte PartmbB
Arabellastraße 30
81925 München (DE)**

(54) **ALTERNATING-CURRENT ROTATING MACHINE CONTROLLER**

(57) To provide a controller for AC rotary machine which can detect the field current flowing through the field winding with good accuracy and can suppress the heat generation of the current detection circuit. A controller for AC rotary machine (11) is provided with a bus current detection circuit (6) that detects a bus current which flows through a connection path between a DC power source (2) and a converter (9) ; a converter switching control unit (31) that switches a power supply path (20) and a circulation path (21) of the converter (9); and a current calculation unit (32) that calculates a field current flowing into the field winding, based on a bus current in suppling power detected when switching to the power supply path (20) and a bus current in circulating detected when switching to the circulation path (21) .

FIG. 1

**Description**

TECHNICAL FIELD

The present disclosure relates to a controller for AC rotary machine.

BACKGROUND ART

The electronic control unit of PLT 1 drives the DC motor by the H bridge circuit, and detects the motor current using the first current detection circuit and the second current detection circuit. Abnormality is determined by mutually comparing the signal of first current detection circuit and the signal of second current detection circuit. Since the motor current always flows into both current detection circuits, it is difficult to obtain offset of current detection on-line.
The electric power steering apparatus of PLT 2 drives the DC motor by H bridge circuit, and using the shunt resistance provided in series on the bus line which connects the DC power source and the H bridge circuit, detects the motor current by detecting the bus current two times in the PWM period for controlling on/off the H bridge circuit.

CITATION LIST

Patent Literature

> PLT 1: JP 2018-182798 A
> PLT 2: JP 4382768 B

SUMMARY OF INVENTION

Technical Problem

In PLT 1, since the current detection circuit is provided in each of the two connection paths which connect the H bridge circuit and the motor, current always flows into the two current detection circuits during the motor current is flowing. Since the shunt resistance is used as the current detection circuit like PLT 1 in many cases, the shunt resistance generates heat during current is flowing. Accordingly, since the motor current always flows through the two current detection circuits, the heat generation in the H bridge circuit becomes large.
In PLT 2, the motor current is switched between the forward direction and the reverse direction in the PWM period, current always flows through the current detection circuit provided in the bus line in the forward direction or the reverse direction in the PWM period. Then, since the motor current is calculated using the difference of the bus currents detected two times in the PWM period, the offset of current detection included in each detection value is canceled. Accordingly, the technology of PLT 2 is suitable for the motor in which current always flows through the bus current detection circuit in the forward direction or the reverse direction. However, in the AC rotary machine which has the AC armature winding and the field winding, the technology of PLT 2 is not suitable for detecting the field current which flows through the field winding. Also in the technology of PLT 2, since current always flows through the current detection circuit, the heat generation of the current detection circuit becomes large.
Thus, it is desirable to provide a controller for AC rotary machine which can detect the field current flowing through the field winding with good accuracy and can suppress the heat generation of the current detection circuit, in the AC rotary machine which has the AC armature winding and the field winding.

Solution to Problem

A controller for AC rotary machine of the present disclosure that controls an AC rotary machine which is provided with an AC armature winding and a field winding, the controller for AC rotary machine including:

> a converter that is provided with switching devices, and that is provided with a power supply path which supplies current to the field winding from a DC power source and a circulation path which circulates current in the converter and supplies a circulating current to the field winding, which are switched by on and off of the switching devices;
> a bus current detection circuit that detects a bus current which is current flowing through a connection path between the DC power source and the converter;
> a converter switching control unit that switches the power supply path and the circulation path, by turning on and off the switching devices of the converter; and

a current calculation unit that calculates a field current which is a current flowing into the field winding, based on a bus current in suppling power which is a bus current detected based on an output signal of the bus current detection circuit when switching to the power supply path, and a bus current in circulating which is a bus current detected based on the output signal of the bus current detection circuit when switching to the circulation path.

Advantage of Invention

According to the controller for AC rotary machine of the present disclosure, when switching to the power supply path, the field current flows through the bus current detection circuit. And, when switching to the circulation path, since current circulates in the converter, the field current does not flow through the bus current detection circuit. Since the field current is calculated based on the bus current in suppling power and the bus current in circulating, the bus current in suppling power which becomes equal to the field current and the bus current in circulating which becomes zero current can be distinguished, and the field current can be calculated with good accuracy. Since current always does not flow through the bus current detection circuit, the heat generation of the bus current detection circuit can be suppressed.

BRIEF DESCRIPTION OF THE DRAWINGS

FIG. 1 is a schematic configuration diagram of the AC rotary machine and the controller for AC rotary machine according to Embodiment 1;
FIG. 2 is a schematic block diagram of the control device according to Embodiment 1;
FIG. 3 is a hardware configuration diagram of the control device according to Embodiment 1;
FIG. 4 is a figure for explaining the voltage vectors of the converter control according to Embodiment 1;
FIG. 5 is a figure for explaining the current path of the voltage vector Vf0 according to Embodiment 1;
FIG. 6 is a figure for explaining the current path of the voltage vector Vf1 according to Embodiment 1;
FIG. 7 is a figure for explaining the current path of the voltage vector Vf2 according to Embodiment 1;
FIG. 8 is a figure for explaining the current path of the voltage vector Vf3 according to Embodiment 1;
FIG. 9 is a time chart for explaining the control behavior of the converter according to Embodiment 1;
FIG. 10 is a schematic diagram of the AC rotary machine used as the generator motor for vehicle according to Embodiment 1;
FIG. 11 is a schematic configuration diagram of the AC rotary machine and the controller for AC rotary machine according to Embodiment 2;
FIG. 12 is a schematic configuration diagram of the AC rotary machine and the controller for AC rotary machine according to Embodiment 3;
FIG. 13 is a schematic configuration diagram of the AC rotary machine and the controller for AC rotary machine according to Embodiment 4;
FIG. 14 is a figure for explaining the voltage vectors of the inverter control according to Embodiment 4;
FIG. 15 is a time chart for explaining the control behavior of the inverter according to Embodiment 4; and
FIG. 16 is a time chart for explaining the control behavior of the inverter according to Embodiment 4.

DETAILED DESCRIPTION OF THE EMBODIMENTS

1. Embodiment 1

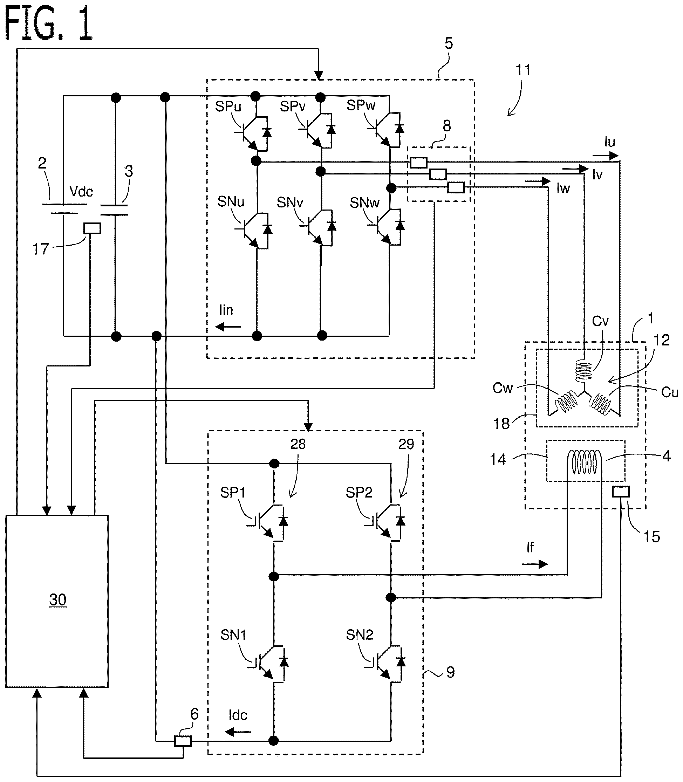

A controller for AC rotary machine 11 (hereinafter, referred to simply as the controller 11) according to Embodiment 1 will be explained with reference to drawings. FIG. 1 is a schematic configuration diagram of the AC rotary machine 1 and the controller 11 according to the present embodiment.

1-1. AC rotary machine

The AC rotary machine 1 is provided with a stator 18 and a rotor 14 disposed on the radial-direction inner side of the stator 18. The AC rotary machine 1 is a field winding type synchronous rotary machine . An AC armature winding 12 is wound around the stator 18. A field winding 4 is wound around the rotor 14, and is provided with an electromagnet.

In the present embodiment, the AC armature winding 12 is three-phase AC armature windings Cu, Cv, Cw of U phase, V phase, and W phase. The three-phase AC armature windings Cu, Cv, Cw may be by a star connection, or may be by a delta connection.

An angle detection circuit 15 which detects a rotational angle (a magnetic pole position) of the rotor 14 is provided in the rotor 14. An output signal of the angle detection circuit 15 is inputted into the control device 30. Various kinds of sensors are used for the angle detection circuit 15.

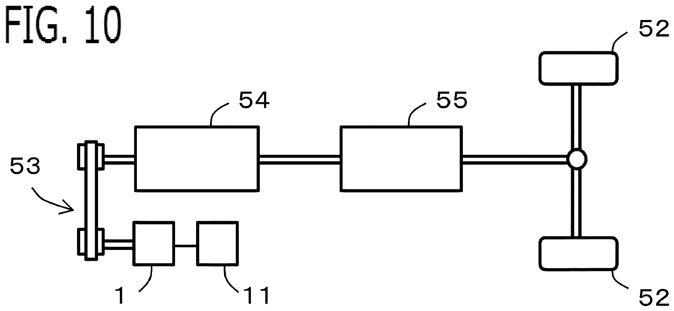

In the present embodiment, the AC rotary machine 1 is a generator motor for vehicle. A rotation axis of the rotor 14 of the AC rotary machine 1 is connected with an internal combustion engine 54 via a connecting mechanism. The rotation axis of the AC rotary machine 1 is connected with the wheels 52 via a connecting mechanism. For example, as shown in FIG. 10, the rotation axis of AC rotary machine 1 is connected with a crankshaft of the internal combustion engine 54 via a pulley and belt mechanism 53. The rotation axis of the AC rotary machine 1 is connected with the wheels 52 via the internal combustion engine 54 and a transmission 55. The AC rotary machine 1 rotates only in one direction, and does not rotate in the other direction.

### 1-2. DC Power Source 2

The DC power source 2 outputs a power source voltage Vdc to the inverter 5 and the converter 9. As the DC power source 2, any apparatus which outputs DC voltage, such as a battery, a DC-DC converter, a diode rectifier, and a PWM rectifier, is used. A smoothing capacitor 3 is connected in parallel to the DC power source 2. A voltage detection circuit 17 for detecting the power source voltage Vdc is provided. An output signal of the voltage detection circuit 17 is inputted into the control device 30.

### 1-3. Inverter 5

The inverter 5 has switching devices and performs power conversion between the DC power source 2 and the AC armature winding 12. The inverter 5 is provided with three sets of series circuits in each of which a positive electrode side switching device connected to the positive electrode side of the DC power source 2 and a negative electrode side switching device connected to the negative electrode side of the DC power source 2 are connected in series, corresponding to respective phase of the three-phase AC armature windings. A connection node of two switching devices in each series circuit is connected to the AC armature winding of the corresponding phase.

Specifically, in the series circuit of U phase, the positive electrode side switching device SPu of U phase and the negative electrode side switching device SNu of U phase are connected in series, and the connection node of two switching devices is connected to the AC armature winding Cu of U phase. In the series circuit of V phase, the positive electrode side switching device SPv of V phase and the negative electrode side switching device SNv of V phase are connected in series, and the connection node of two switching devices is connected to the AC armature winding Cv of V phase. In the series circuit of W phase, the positive electrode side switching device SPw of W phase and the negative electrode side switching device SNw of W phase are connected in series, and the connection node of two switching devices is connected to the AC armature winding Cw of W phase.

IGBT (Insulated Gate Bipolar Transistor) in which a diode is connected in inverse parallel, a bipolar transistor in which a diode is connected in inverse parallel, MOSFET (Metal Oxide Semiconductor Field Effect Transistor), or the like is used for the switching device of the inverter 5. A gate terminal of each switching device is connected to the control device 30 via a gate drive circuit and the like. The each switching device is turned on or turned off by the switching signal outputted from the control device 30.

### 1-4. Converter 9

The converter 9 is provided with switching devices and performs power conversion between the DC power source 2 and the field winding 4. The converter 9 is provided with a power supply path 20 which supplies current to the field winding 4 from the DC power source 2 and a circulation path 21 which circulates current in the converter 9 and supplies a circulating current to the field winding 4, which are switched by on and off of the switching devices.

In the present embodiment, the converter 9 is H bridge circuit which is provided with two sets of series circuits in each of which a positive electrode side switching device connected to the positive electrode side of the DC power source 2 and a negative electrode side switching device connected to the negative electrode side of the DC power source 2 are connected in series. The connection node of the positive electrode side switching device SP1 and the negative electrode side switching device SN1 in the first set of series circuit 28 is connected to one end of the field winding 4. The connection node of the positive electrode side switching device SP2 and the negative electrode side switching device SN2 in the second set of series circuit 29 is connected to the other end of the field winding 4.

IGBT in which the diode is connected in inverse parallel, the bipolar transistor in which the diode is connected to in inverse parallel, MOSFET, or the like is used for the switching device of the converter 9. A gate terminal of each switching device is connected to the control device 30 via a gate drive circuit and the like. The each switching device is turned on or turned off by the switching signal outputted from the control device 30.

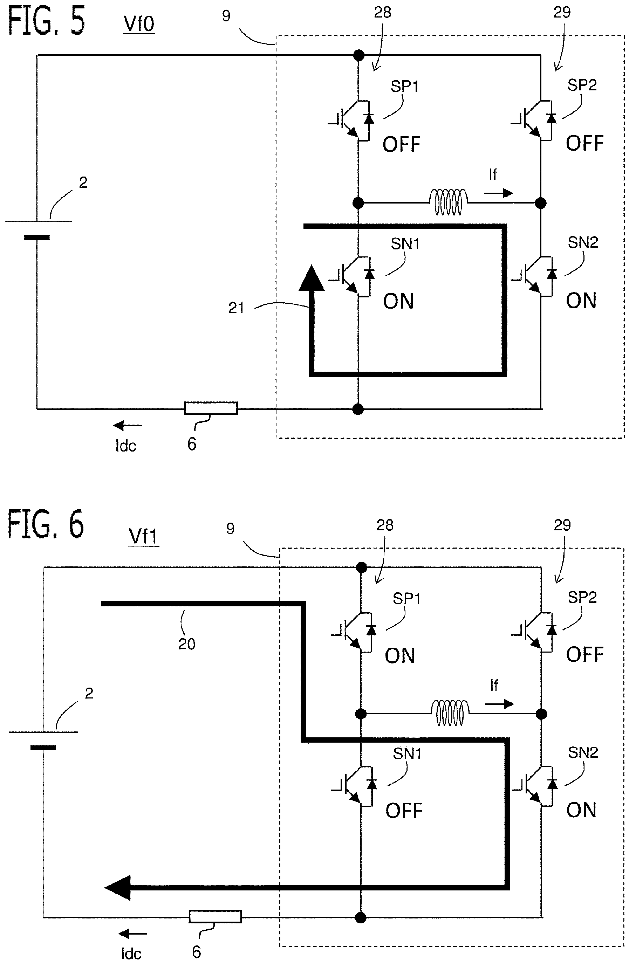

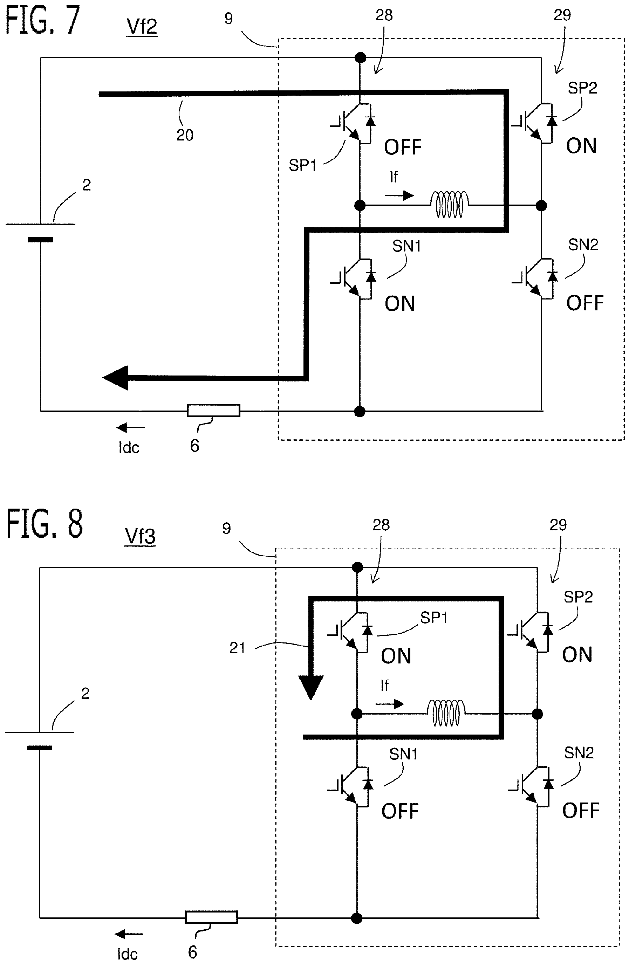

When the switching devices of the converter 9 are turned on and off as shown in FIG. 6 described below, the converter 9 switches to the power supply path 20. On the other hand, when the switching devices of the converter 9 are turned on and off as shown in FIG. 5 or FIG. 8 described below, the converter 9 switches to the circulation path 21. In the present embodiment, it is designed on the assumption that current flows through the field winding 4 only in the first direction which is from the first set of series circuit 28 side to the second set of series circuit 29.

1-5. Armature Current Detection Circuit 8

The armature current detection circuit 8 is a current detection circuit which detects current flowing into the AC armature winding Cu, Cv, Cw of each phase. In the present embodiment, the armature current detection circuit 8 is provided on a wire of each phase which connects the series circuit of the switching devices and the AC armature winding. The output signal of the armature current detection circuit 8 of each phase is inputted into the control device 30. The armature current detection circuit 8 is a non-contact type current sensor, such as a Hall element. The armature current detection circuit 8 may be a shunt resistance connected in series to the series circuit of the switching devices of each phase.

1-6. Bus Current Detection Circuit 6

The bus current detection circuit 6 is a current detection circuit which detects a bus current Idc which is current flowing through a connection path between the DC power source 2 and the converter 9. In the present embodiment, the bus current detection circuit 6 detects the bus current Idc which is current flowing through a part which is the connection path between DC power source 2 and the converter 9 and is not common with the connection path between the DC power source 2 and the inverter 5. The bus current detection circuit 6 is provided in the connection path which connects between the converter 9 and the negative electrode side of the DC power source 2. The bus current detection circuit 6 may be provided in the connection path which connects between the converter 9 and the positive electrode side of the DC power source 2. An output signal of the bus current detection circuit 6 is inputted into the control device 30.

If the shunt resistance is used for the bus current detection circuit 6, when it is cut off by heat generation, power cannot be supplied to the converter 9 from the DC power source 2. Accordingly, the bus current detection circuit 6 is preferably a non-contact type current sensor, such as a Hall element. Even if abnormality occurs in the non-contact type current sensor, there is no influence on the power supply system. If heat dissipation is secured and there is no difficulty in heat generation aspect, the shunt resistance may be used for the bus current detection circuit 6.

1-7. Control Device 30

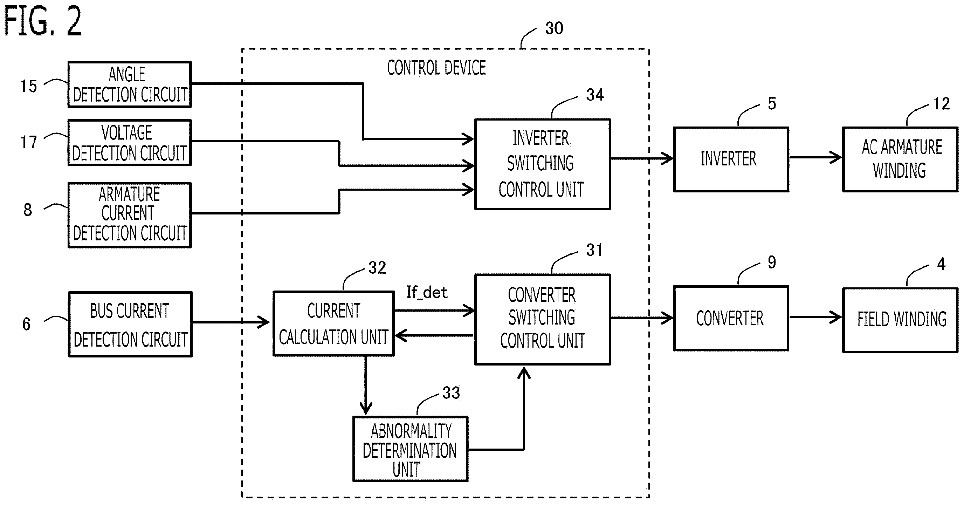

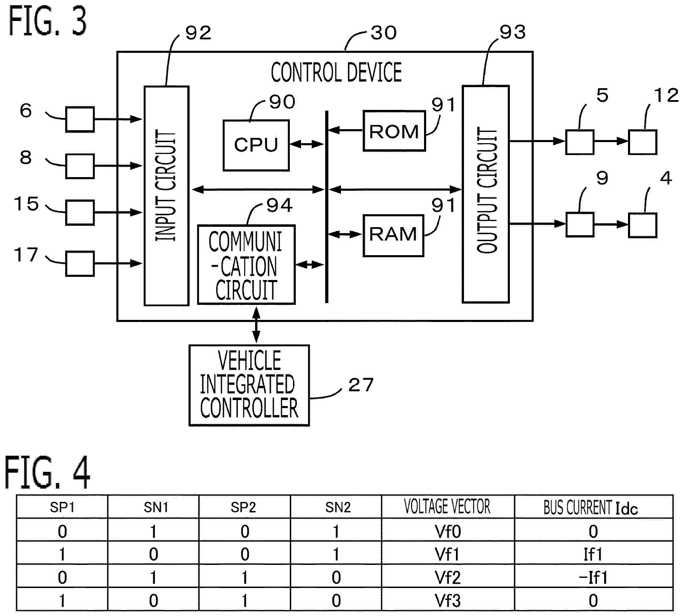

The control device 30 controls the AC rotary machine 1 via the inverter 5 and the converter 9. The control device 30 is provided with functional parts, such as a converter switching control unit 31, a current calculation unit 32, an abnormality determination unit 33, and an inverter switching control unit 34, as shown in FIG. 2. Respective functions of the control device 30 are realized by processing circuits provided in the control device 30. Specifically, as illustrated in FIG. 3, the control device 30 is provided with, as processing circuits, an arithmetic processor (computer) 90 such as a CPU (Central Processing Unit), storage apparatuses 91 which exchange data with the arithmetic processor 90, an input circuit 92 which inputs external signals to the arithmetic processor 90, an output circuit 93 which outputs signals from the arithmetic processor 90 to the outside, a communication circuit 94 which performs data communication with external apparatuses, and the like.

As the arithmetic processor 90, ASIC (Application Specific Integrated Circuit), IC (Integrated Circuit), DSP (Digital Signal Processor), FPGA (Field Programmable Gate Array), various kinds of logical circuits, various kinds of signal processing circuits, and the like may be provided. As the arithmetic processor 90, a plurality of the same type ones or the different type ones may be provided, and each processing may be shared and executed. As the storage apparatuses 91, there are provided a RAM (Random Access Memory) which can read data and write data from the arithmetic processor 90, a ROM (Read Only Memory) which can read data from the arithmetic processor 90, and the like. The input circuit 92 is connected with various kinds of sensors and switches such as the angle detection circuit 15, the voltage detection circuit 17, the armature current detection circuit 8, the bus current detection circuit 6, and is provided with A/D converter, input port, and the like for inputting output signals from the sensors and the switches to the arithmetic processor 90. The output circuit 93 is connected with electric loads such as a gate drive circuit which drive on and off of the switching devices of the inverter 5 and the converter 9, and is provided with driving circuit and the like for outputting a control signal from the arithmetic processor 90. The communication circuit 94 communicates with the vehicle integrated controller 27 and the like.

Then, the arithmetic processor 90 runs software items (programs) stored in the storage apparatus 91 such as a ROM and collaborates with other hardware devices in the control device 30, such as the storage apparatus 91, the input circuit 92, and the output circuit 93, so that the respective functions of the control units 31 to 34 provided in the control device 30 are realized. Setting data items such as a determination value to be utilized in the control units 31 to 34 are stored, as part of software items (programs), in the storage apparatus 91 such as a ROM. Each function of the control device 30 will be described in detail below.

1-7-1. Inverter Switching Control Unit 34

The inverter switching control unit 34 applies voltage to the AC armature winding Cu, Cv, Cw of each phase by turning on and off the switching devices of the inverter 5. The inverter switching control unit 34 calculates three-phase voltage commands applied to the AC armature windings of respective phases. The inverter switching control unit 34 calculates the three-phase voltage commands, using well-known vector control or V/f control.

The inverter switching control unit 34 detects a rotational angle and a rotational angle speed of the rotor 14, based on the output signal of the angle detection circuit 15. The inverter switching control unit 34 detects three-phase armature currents which flow into the AC armature windings of respective phases, based on the output signal of the armature current detection circuit 8. The inverter switching control unit 34 detects a power source voltage Vdc, based on the output signal of the voltage detection circuit 17.

If the vector control is used, the inverter switching control unit 34 calculates the three-phase voltage commands, based on a torque command, the detection values of armature currents, the rotational angle, the rotational angle speed, the power source voltage, and the like. The torque command may be transmitted from the vehicle integrated controller 27 or the like, or may be calculated in the control device 30. Specifically, the inverter switching control unit 34 calculates dq-axis current commands, based on the torque command, the rotational angle speed, the power source voltage Vdc, and the like; calculates dq-axis current detection values, based on the detection values of three-phase armature currents and the rotational angle; calculates dq-axis voltage commands by performing a current feedback control on a dq-axis coordinate system, based on the dq-axis current commands and the dq-axis current detection values; and calculates three-phase voltage commands, based on the dq-axis voltage commands and the rotational angle. The inverter switching control unit 34 may perform a feedforward control which changes the dq-axis voltage commands using the specifications of the AC rotary machine based on the dq-axis current commands without using the current detection values. Then, the inverter switching control unit 34 may converts the dq-axis voltage commands into the three-phase voltage commands based on the rotational angle. The inverter switching control unit 34 may add a modulation which does not change the line voltage, such as the space vector modulation or the two-phase modulation, to the three-phase voltage commands.

If the V/f control is used, the inverter switching control unit 34 determines an amplitude V of voltage command, based on a rotational frequency command f of the AC rotary machine transmitted from the vehicle integrated controller 27 or the like. Then, the inverter switching control unit 34 calculates the three-phase voltage commands, based on the amplitude V of voltage command and a phase obtained by integrating the rotational frequency command f.

The inverter switching control unit 34 turns on and off the plurality of switching devices by PWM (Pulse Width Modulation) control, based on the three-phase voltage commands. The inverter switching control unit 34 generates a switching signal which turns on and off the switching devices of each phase, by comparing each of three-phase voltage commands and a carrier wave. The carrier wave is a triangular wave which has an amplitude of the power source voltage Vdc and oscillates at a carrier frequency. The inverter switching control unit 34 turns on the switching signal when the voltage command exceeds the carrier wave, and turns off the switching signal when the voltage command is below the carrier wave. The switching signal is transmitted as it is to the positive electrode side switching device, and a switching signal obtained by reversing the switching signal is transmitted to the negative electrode side switching device. Each switching signal is inputted into the gate terminal of each switching device of the inverter 5 via the gate drive circuit, and each switching device is turned on or turned off.

1-7-2. Converter Switching Control Unit 31

The converter switching control unit 31 applies voltage to the field winding 4 by turning on and off the switching devices of the converter 9. The converter switching control unit 31 switches the power supply path 20 and the circulation path 21, by turning on and off the switching devices of the converter 9.

In the present embodiment, the converter switching control unit 31 turns on and off the switching devices of the converter 9, based on the voltage command of the field winding applied to the field winding 4. The converter switching control unit 31 performs a current feedback control which changes the voltage command of field winding so that a field current detection value If_det calculated by the current calculation unit 32 described below approaches a field current command. The converter switching control unit 31 calculates the field current command, based on the torque command and the like. The torque command may be transmitted from the vehicle integrated controller 27 or the like, or may be calculated in the control device 30.

There are four on-off patterns of the four switching devices of the converter 9 which is H bridge circuit, as shown in FIG. 4. In FIG. 4, "0" indicates that the corresponding switching device is OFF, and "1" indicates that the corresponding switching device is ON. The four on-off patterns are referred to as voltage vectors Vf0, Vf1, Vf2, Vf3.

<Voltage vector Vf0>

As shown in FIG. 4 and FIG. 5, in the voltage vector Vf0,the positive electrode side switching device SP1 of first set is set to "0" (OFF), the negative electrode side switching device SN1 of first set is set to "1" (ON), the positive electrode side switching device SP2 of second set is set to "0" (OFF), and the negative electrode side switching device SN2 of second set is set to "1" (ON). In the voltage vector Vf0,the power source voltage Vdc is not applied to the field winding 4, but current circulates in the converter 9, and a circulating current flows into the field winding 4. And, when the voltage vector Vf1 is set just before, current flows through the field winding 4 in a first direction, as shown in FIG. 5. On the other hand, when the voltage vector Vf2 is set just before, current flows through the field winding 4 in a second direction which is opposite direction of FIG. 5. The voltage vector Vf0 is a zero vector that current does not flow between the DC power source 2 and the converter 9.

<Voltage vector Vf1>

As shown in FIG. 4 and FIG. 6, in the voltage vector Vf1, the positive electrode side switching device SP1 of first set is set to "1" (ON), the negative electrode side switching device SN1 of first set is set to "0" (OFF), the positive electrode side switching device SP2 of second set is set to "0" (OFF), and the negative electrode side switching device SN2 of second set is set to "1" (ON). In the voltage vector Vf1, the power source voltage Vdc is applied to the field winding 4, and current flows into the field winding 4 from the DC power source 2. Current flows through the field winding 4 in the first direction which is from the first set of series circuit 28 side to the second set of series circuit 29 side. In the present embodiment, the AC rotary machine 1 is designed on the assumption that current flows only in this first direction, and the voltage vector Vf2 in which current flows in the second direction described below is not used. The voltage vector Vf0 is an effective vector that current flows between the DC power source 2 and the converter 9.

<Voltage vector Vf2>

As shown in FIG. 4 and FIG. 7, in the voltage vector Vf2, the positive electrode side switching device SP1 of first set is set to "0" (OFF), the negative electrode side switching device SN1 of first set is set to "1" (ON), the positive electrode side switching device SP2 of second set is set to "1" (ON), and the negative electrode side switching device SN2 of second set is set to "0" (OFF) . In the voltage vector Vf2, the power source voltage Vdc is applied to the field winding 4, and current flows into the field winding 4 from the DC power source 2. And, current flows through the field winding 4 in the second direction which is from the second set of series circuit 29 side to the first set of series circuit 28 side. In the present embodiment, the AC rotary machine 1 is designed on the assumption that current does not flow in this second direction. The voltage vector Vf2 is an effective vector that current flows between the DC power source 2 and the converter 9, but it is not used in the present embodiment.

<Voltage vector Vf3>

As shown in FIG. 4 and FIG. 8, in the voltage vector Vf3, the positive electrode side switching device SP1 of first set is set to "1" (ON), the negative electrode side switching device SN1 of first set is set to "0" (OFF), the positive electrode side switching device SP2 of second set is set to "1" (ON), and the negative electrode side switching device SN2 of second set is set to "0" (OFF) . In the voltage vector Vf3, the power source voltage Vdc is not applied to the field winding 4, but current circulates in the converter 9, and a circulating current flows into the field winding 4. And, when the voltage vector Vf1 is set just before, current flows through the field winding 4 in the first direction, as shown in FIG. 8. On the other hand, when the voltage vector Vf2 is set just before, current flows through the field winding 4 in the second direction which is an opposite direction of FIG. 8. The voltage vector Vf3 is a zero vector that current does not flow between the DC power source 2 and the converter 9.

<Switching of voltage vectors by PWM control>

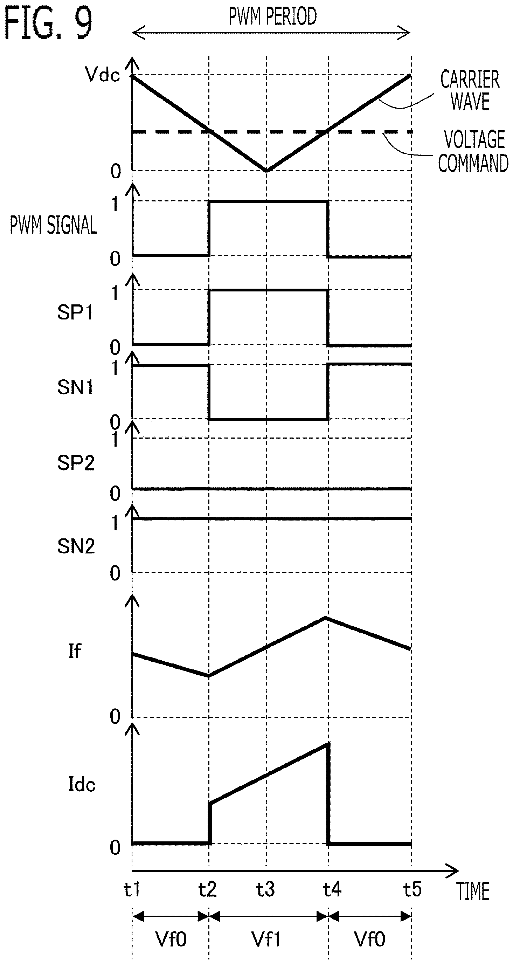

As shown in FIG. 9, the converter switching control unit 31 generates a PWM signal of ON duty ratio which is a ratio obtained by dividing the voltage command of field winding by the power source voltage Vdc, and turns on and off the switching devices of the converter 9 based on the PWM signal.
For example, the converter switching control unit 31 compares the voltage command of field winding with a carrier wave (a triangular wave) which oscillates between 0 and the power source voltages Vdc with a PWM period, turns on the PWM signal (1) when the voltage command exceeds the carrier wave, and turns off the PWM signal (0) when the voltage command is below the carrier wave. Alternatively, the converter switching control unit 31 may generate the PWM signal of the ON duty ratio simply.

Then, the converter switching control unit 31 turns on and off the switching devices of the converter 9 so as to become the power supply path 20 when the PWM signal is ON (1), and turns on and off the switching devices of the converter 9 so as to become the circulation path 21 when the PWM signal is OFF (0). In the present embodiment, the converter switching control unit 31 turns on and off the switching devices of the converter 9 by on-off pattern of the voltage vector Vf1 when the PWM signal is ON (1), and turns on and off the switching devices of the converter 9 by on-off pattern of the voltage vector Vf0 when the PWM signal is OFF (0). The converter switching control unit 31 may turn on and off the switching devices of the converter 9 by on-off pattern of the voltage vector Vf3 when the PWM signal is OFF (0). Alternatively, the converter switching control unit 31 may switch periodically the voltage vector which is set when the PWM signal is OFF (0) between the voltage vector Vf0 and the voltage vector Vf3.

1-7-3. Current Calculation Unit 32

As shown in FIG. 9, the field current If which flows through the field winding 4 increases monotonically when switching to the power supply path 20, and decreases monotonically when switching to the circulation path 21. The bus current detection circuit 6 is a bus current Idc which flows through a connection path between the DC power source 2 and the converter 9. Accordingly, as shown in FIG. 9 and FIG. 6, when switching to the power supply path 20, since the field current If flows through the arrangement point of the bus current detection circuit 6, the field current If can be detected by the bus current Idc. On the other hand, as shown in FIG. 9 and FIG. 5, when switching to the circulation path 21, since the field current If does not flow through the arrangement point of the bus current detection circuit 6, the bus current Idc becomes zero and the field current If cannot be detected. Therefore, if the bus current detection circuit 6 is used, it is necessary to detect the field current If considering the switching between the power supply path 20 and the circulation path 21.

The current calculation unit 32 detects the bus current Idc_det (hereinafter, referred to as a bus current detection value Idc_det), based on the output signal of the bus current detection circuit 6. The current calculation unit 32 calculates the field current detection value If_det, based on a bus current detection value in suppling power Idc_det1 which is the bus current detection value detected when switching to the power supply path 20, and a bus current detection value in circulating Idc_det2 which is the bus current detection value Idc_det detected when switching to the circulation path 21.

According to this configuration, the bus current detection value in suppling power Idc_det1 which becomes equal to the field current If, and the bus current detection value in circulating Idc_det2 which becomes zero current can be distinguished, and the field current detection value If_det can be calculated with good accuracy.

<Offset compensation of bus current detection circuit 6>

Offset may occur in the output signal of the bus current detection circuit 6. When offset does not occur, the bus current detection value in circulating Idc_det2 becomes zero. But, when offset occurs, the bus current detection value in circulating Idc_det2 is shifted from zero by the offset.

Then, the current calculation unit 32 calculates the field current detection value If_det, by subtracting the bus current detection value in circulating Idc_det2 from the bus current detection value in suppling power Idc_det1. Accordingly, the offset of bus current detection value Idc_det can be canceled, and accuracy of the field current detection value If_det can be improved.

Since offset of the bus current detection circuit 6 occurs due to a temperature drift in many cases, and the time constant of temperature change is large, the offset changes sufficiently slowly compared with the PWM period. Therefore, it is not necessary to detect the bus current detection value in circulating Idc_det2 in every PWM period.

Then, the current calculation unit 32 may make a detection frequency of the bus current detection value in circulating Idc_det2 lower than a detection frequency of the bus current detection value in suppling power Idc_det1. For example, the current calculation unit 32 may detect the bus current detection value in suppling power Idc_det1 in every PWM period, and may detect the bus current detection value in circulating Idc_det2 in every plurality of PWM periods. The current calculation unit 32 may calculate the field current detection value If_det, by subtracting an average value of the bus current detection values in circulating Idc_det2 detected at the past plural times, from the bus current detection value in suppling power Idc_det1.

<Current detection timing>

As shown in FIG. 9, the current calculation unit 32 detects the bus current detection value in suppling power Idc_det1 by the bus current detection circuit 6 at a center timing (time t3) of a period when switching to the power supply path 20. According to this configuration, in the period when switching to the power supply path 20, a center value of the field current If which is increasing monotonically can be detected, and an average value of the field current If during the PWM period can be detected. Therefore, accuracy of the field current detection value If_det can be improved. And, the period when switching to the power supply path 20 can be decreased to a limit that current can be detected. In the case of the DC motor of PLT 2, if the ON duty ratio is limited so as to become larger than the limit that current can be detected, the limit is outputted as torque as it is. On the other hand, in the AC rotary machine of the present embodiment, since current needs to flow into the AC armature windings in order to convert the magnetic flux obtained by the field winding current into torque, the lower limit of the period when switching to the power supply path 20 can be set.

And, the current calculation unit 32 detects the bus current detection value in circulating Idc_det2 by the bus current detection circuit 6 at a center timing (time t1, time t5) of a period when switching to the circulation path 21. According to this configuration, since detection becomes difficult to be affected by the influence on the current by turning on and off the switching devices, accuracy of the field current detection value If_det can be improved. The period when switching to the circulation path 21 can be decreased to the limit that current can be detected.

In the present embodiment, the current calculation unit 32 detects current at the timings of mountain and valley of the carrier wave.

<Setting of switching period>

There is a response delay until current flowing through the switching device is stabilized after turning on or turning off the switching device. If ON period or OFF period of the switching device is too short, current cannot be detected in a state where current is stabilized after turning on or off the switching device, and the detection accuracy of current is deteriorated.

Then, the current calculation unit 32 switches to the power supply path 20 during a period longer than a current stable period until current is stabilized after turning on or off the switching device, and detects the bus current detection value in suppling power Idc_det1. And, the current calculation unit 32 switches to the circulation path 21 during a period longer than the current stable period, and detects the bus current detection value in circulating Idc_det2. According to this configuration, current can be detected in the state where current is stabilized after turning on or off the switching device, and accuracy of the field current detection value If_det can be improved.

1-7-4. Abnormality Determination Unit 33

<Abnormality determination in suppling current>

The abnormality determination unit 33 determines abnormality of the bus current detection circuit 6. The abnormality determination unit 33 sets a normal current range in suppling power, based on a ratio of the period switching to the power supply path 20 and the period switching to the circulation path 21 (in this example, an ON duty ratio or the voltage command of field winding), and determines that abnormality occurred in the bus current detection circuit 6, when the bus current detection value in suppling power Idc_det1 deviates from the normal current range in suppling power. For example, the abnormality determination unit 33 calculates a maximum value Idcmax1 and a minimum value Idcmin1 of the normal current range in suppling power, based on the voltage command of field winding, and determines whether the bus current detection value in suppling power Idc_det1 is less than or equal to the maximum value Idcmax1 and is greater than or equal to the minimum values Idcmin1 of the normal current range in suppling power.

The abnormality determination unit 33 may determine the abnormality of the bus current detection circuit 6 using the field current detection value If_det instead of the bus current detection value in suppling power Idc_det1.

For example, the abnormality determination unit 33 sets the maximum value Idcmax1 and the minimum value Idcmin1 of the normal current range in suppling power, based on a maximum value Rf1_max and a minimum value Rf1_min of a fluctuation range of a resistance of the field winding due to temperature change, and the voltage command Vf of field winding. Alternatively, the maximum value Idcmax1 and the minimum value Idcmin1 may be set considering other variations and a margin.

$$Idcmax1 = (Vf - Vfb)/(Rf1\_min)$$

$$Idcmin1 = (Vf - Vfb)/(Rf1\_max) \quad \ldots \quad (1)$$

Herein, Vfb is a voltage drop due to a brush mechanism for connecting the converter 9 and the field winding 4 of the rotor, and the like.

<Abnormality determination in circulating>

The abnormality determination unit 33 determines that abnormality occurred in the bus current detection circuit 6, when the bus current detection value in circulating Idc_det2 deviates from a preliminarily set normal current range in circulating. For example, the abnormality determination unit 33 calculates a maximum value Idcmax2 and a minimum value Idcmin2 of the normal current range in circulating, and determines whether the bus current detection value in circulating Idc_det2 is less than or equal to the maximum value Idcmax2 and is greater than or equal to the minimum values Idcmin2 of the normal current range in circulating. The maximum value Idcmax2 and the minimum value Idcmin2 of the normal current range in circulating may be set to values considering characteristics variation, temperature change, aging change, and the like of element of the bus current detection circuit 6, respectively.

2. Embodiment 2

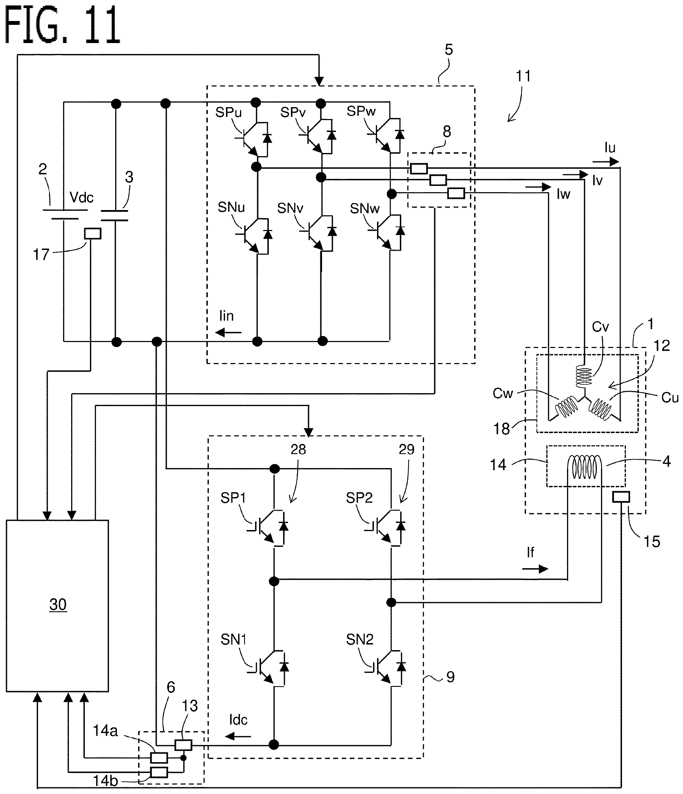

Next, the AC rotary machine 1 and the controller 11 according to Embodiment 2 will be explained. The explanation for constituent parts the same as those in Embodiment 1 will be omitted. The basic configuration of the AC rotary machine 1 and the controller 11 according to the present embodiment is the same as that of Embodiment 1. However, Embodiment 2 is different from Embodiment 1 in the configuration of the bus current detection circuit 6 and the processing using the output signal of the bus current detection circuit 6. FIG. 11 is a schematic configuration diagram of the AC rotary machine 1 and the controller 11 according to the present embodiment.

In the present embodiment, the bus current detection circuit 6 is provided with one current detector 13, and a plurality of signal processors each of which process an output signal of the current detector 13 and outputs a process signal to the control device 30 (the current calculation unit 32). As the plurality of signal processors, a first signal processor 14a and a second signal processor 14b are provided. Hall element or shunt resistance is used for the current detector 13. A processing device adjusted to a kind of the current detector is provided in the first and the second signal processors 14a, 14b.

Similar to Embodiment 1, the current calculation unit 32 detects a first bus current detection value in suppling power Idc_det1a and detects a first bus current detection value in circulating Idc_det2a, based on the output signal of the first signal processor 14a of the bus current detection circuit 6. And, similar to Embodiment 1, the current calculation unit 32 detects a second bus current detection value in suppling power Idc_det1b and detects a second bus current detection value in circulating Idc_det2b, based on the output signal of the second signal processor 14b of the bus current detection circuit 6.

Then, similar to Embodiment 1, the current calculation unit 32 calculates a first field current detection value If_deta, based on the first bus current detection value in suppling power Idc_det1a and the first bus current detection value in circulating Idc_det2a. Similar to Embodiment 1, the current calculation unit 32 calculates a second field current detection value If_detb, based on the second bus current detection value in suppling power Idc_det1b and the second bus current detection value in circulating Idc_det2b.

The converter switching control unit 31 calculates the voltage command of field winding, using one or both of the first field current detection value If_deta and the second field current detection value If_detb.

Using the same method as Embodiment 1, the abnormality determination unit 33 determines abnormality of the bus current detection circuit 6, based on each of the first bus current detection value detected by the first signal processor 14a, and the second bus current detection value detected by the second signal processor 14b.

Since one signal processor is provided in Embodiment 1, it is not easy to determine abnormality, when an abnormality in which a gain of the signal processor is varied minutely occurred. Then, in the present embodiment, the abnormality determination unit 33 determines that abnormality occurred in the bus current detection circuit 6, when the first bus current detection value in suppling power Idc_det1a and the second bus current detection value in suppling power Idc_det1b do not coincide mutually. By mutually comparing in this way, even when the abnormality in which the gain of the signal processor is varied minutely occurs, abnormality can be determined.

For example, as shown in the next equation, the abnormality determination unit 33 determines that abnormality occurred, when an absolute value of a deviation between the first bus current detection value in suppling power Idc_det1a and the second bus current detection value in suppling power Idc_det1b becomes larger than a preliminarily set determination threshold value THab.

$$|Idc\_det1a - Idc\_det1b| > THab \qquad \dots (2)$$

Alternatively, the abnormality determination unit 33 may determine that abnormality occurred in the bus current detection circuit 6, when the first field current detection value If_deta and the second field current detection value If_detb do not coincide mutually. In this case, similarly, as shown in the next equation, the abnormality determination unit 33 determines that abnormality occurred, when an absolute value of a deviation between the first field current detection value If_deta and the second field current detection value If_detb becomes larger than a preliminarily set determination threshold value THab.

$$\left| If\_deta - If\_detb \right| > THab \quad \dots \ (3)$$

3. Embodiment 3

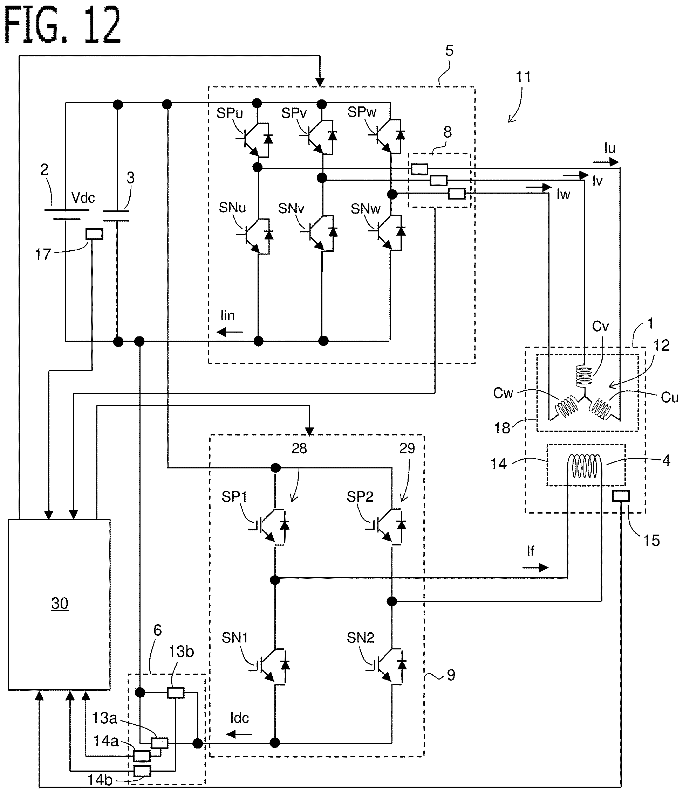

Next, the AC rotary machine 1 and the controller 11 according to Embodiment 3 will be explained. The explanation for constituent parts the same as those in Embodiment 1 will be omitted. The basic configuration of the AC rotary machine 1 and the controller 11 according to the present embodiment is the same as that of Embodiment 1. However, Embodiment 3 is different from Embodiment 1 in the configuration of the bus current detection circuit 6 and the processing using the output signal of the bus current detection circuit 6. FIG. 12 is a schematic configuration diagram of the AC rotary machine 1 and the controller 11 according to the present embodiment.

In the present embodiment, the connection path between DC power source 2 and the converter 9 is provided with a plurality of parallel connection path parts which branch into plurality and are arranged in parallel. Then, the bus current detection circuit 6 is provided with a plurality of current detectors each of which detect current flowing through each of the plurality of parallel connection path parts, and a plurality of signal processors each of which processes an output signal of each of the plurality of current detectors and outputs a process signal to the control device 30 (the current calculation unit 32), and whose number is the same as number of the plurality of current detectors. If shunt resistance is used for the current detector, there is anxiety that shunt resistance is cut off at the time of overcurrent. Since the plurality of current detectors are connected in parallel between the DC power source and the converter 9, even if one is cut off, power can be supplied by others.

In the present embodiment, the plurality of parallel connection path parts are provided in the connection path which connects the converter 9 and the negative electrode side of DC power source 2. As the plurality of parallel connection path parts, a first parallel connection path part and a second parallel connection path part are provided. As the plurality of current detectors, a first current detector 13a and a second current detector 13b are provided. As the plurality of signal processors, a first signal processor 14a and a second signal processor 14b are provided. Accordingly, the first signal processor 14a processes the output signal of the first current detector 13a, and outputs it to the control device 30. The second signal processor 14b processes the output signal of the second current detector 13b, and outputs it to the control device 30. Hall element or shunt resistance is used for the first and the second current detectors 13a, 13b. A processing device adjusted to a kind of the current detector is provided in the first and the second signal processors 14a, 14b.

Similar to Embodiment 1, the current calculation unit 32 detects a first bus current detection value in suppling power Idc_det1a and detects a first bus current detection value in circulating Idc_det2a, based on the output signal of the first signal processor 14a of the bus current detection circuit 6. And, similar to Embodiment 1, the current calculation unit 32 detects a second bus current detection value in suppling power Idc_det1b and detects a second bus current detection value in circulating Idc_det2b, based on the output signal of the second signal processor 14b of the bus current detection circuit 6.

Then, similar to Embodiment 1, the current calculation unit 32 calculates a first field current detection value If_deta, based on the first bus current detection value in suppling power Idc_det1a and the first bus current detection value in circulating Idc_det2a. Similar to Embodiment 1, the current calculation unit 32 calculates a second field current detection value If_detb, based on the second bus current detection value in suppling power Idc_det1b and the second bus current detection value in circulating Idc_det2b.

On the other hand, in the present embodiment, since bus current is branched into the two parallel connection path parts, it is necessary to calculate the final bus current and the final field current by totaling both. Then, the current calculation unit 32 calculates the field current detection value If_det by totaling the first field current detection value If_deta and the second field current detection value If_detb. Then, the converter switching control unit 31 calculates the voltage command of field winding using the field current detection value If_det after totaling.

Using the same method as Embodiment 1, the abnormality determination unit 33 determines abnormality of the bus current detection circuit 6, based on the bus current detection value in suppling power Idc_det1 obtained by totaling the first bus current detection value in suppling power Idc_det1a and the second bus current detection value in suppling power Idc_det1b, the field current detection value If_det after totaling, the first bus current detection value in circulating Idc_det2a, and the second bus current detection value in circulating Idc_det2b.

Since the bus current is branched into the two parallel connection path parts, as shown in the next equation, a ratio of a first bus current Idca and a second bus current Idcb becomes equal to a ratio of a reciprocal of first resistance Ra of the first parallel connection path part and a reciprocal of second resistance Rb of the second parallel connection path part. If the first and the second current detectors 13a, 13b are shunt resistances, a resistance of shunt resistance is added to the first and the second resistance Ra, Rb.

$$Idca:Idcb=1/Ra:1/Rb \quad ... \quad (4)$$

Then, the abnormality determination unit 33 determines that abnormality occurred in the bus current detection circuit 6, when a ratio of the first bus current detection value in suppling power Idc_det1a and the second bus current detection value in suppling power Idc_det1b does not coincide with a preliminarily set normal ratio.

For example, as shown in the next equation, the abnormality determination unit 33 determines that abnormality occurred, when an absolute value of a deviation between a multiplication value of the first bus current detection value in suppling power Idc_det1a and the second resistance Rb, and a multiplication value of the second bus current detection value in suppling power Idc_det1b and the first resistance Ra becomes larger than a preliminarily set determination threshold value THab2.

$$|Rb×Idc\_det1a-Ra×Idc\_det1b|>THab2 \quad ... \quad (5)$$

Alternatively, the abnormality determination unit 33 may determine that abnormality occurred in the bus current detection circuit 6, when a ratio of the first field current detection value If_deta and the second field current detection value If_detb does not coincide with a preliminarily set normal ratio. In this case, similarly, as shown in the next equation, the abnormality determination unit 33 determines that abnormality occurred, when an absolute value of a deviation between a multiplication value of the first field current detection value If_deta and the second resistance Rb, and a multiplication value of the second field current detection value If_detb and the first resistance Ra becomes larger than a preliminarily set determination threshold value THab2.

$$|Rb×If\_deta-Ra×If\_detb|>THab2 \quad ... \quad (6)$$

4. Embodiment 4

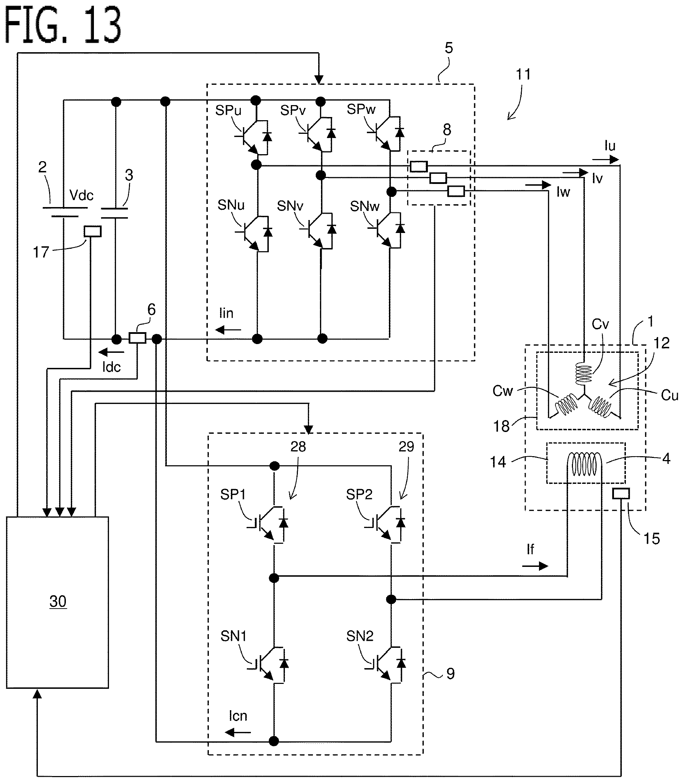

Next, the AC rotary machine 1 and the controller 11 according to Embodiment 4 will be explained. The explanation for constituent parts the same as those in Embodiment 1 will be omitted. The basic configuration of the AC rotary machine 1 and the controller 11 according to the present embodiment is the same as that of Embodiment 1. However, Embodiment 4 is different from Embodiment 1 in the arrangement position of the bus current detection circuit 6. FIG. 13 is a schematic configuration diagram of the AC rotary machine 1 and the controller 11 according to the present embodiment.

In the present embodiment, the bus current detection circuit 6 detects, as the bus current, current which flows through a path which is common between a connection path between the DC power source 2 and the converter 9, and a connection path between the DC power source 2 and the inverter 5.

Accordingly, the bus current Idc detected by the bus current detection circuit 6 becomes current which mixed a converter current Icn which is current flowing between the DC power source 2 and the converter 9, and an inverter current Iin which is current flowing between the DC power source 2 and the inverter 5. Accordingly, it is necessary to extract only the converter current Icn from the bus current.

<On-off pattern of inverter in which inverter current becomes zero>

When the inverter current Iin is not flowing, the bus current Idc becomes equal to the converter current Icn. Then, the on-off pattern of the switching devices of the inverter 5 in which the inverter current Iin becomes zero will be explained.

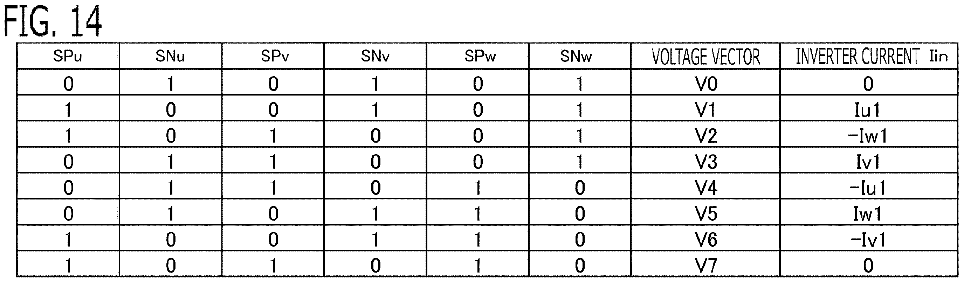

As shown in FIG. 14, there are eight on-off patterns of six switching devices of the inverter 5. In FIG. 14, "0" indicates that the corresponding switching device is off, and "1" indicates that the corresponding switching device is on. The eight on-off patterns are referred to as voltage vectors V0 to V7.

In the voltage vector V0, all the negative electrode side switching devices SNu, SNv, SNw of U phase, V phase, and W phase are become ON, all the positive electrode side switching devices SPu, SPv, SPw of U phase, V phase, and W phase are become OFF, and the terminals of the three-phase AC armature windings Cu, Cv, Cw are mutually connected via the negative electrode side electric wire. In this voltage vector V0, current circulates between the three-phase AC armature windings and the inverter, the inverter current Iin becomes zero, and it becomes a state of the zero vector in which current does not flow between the DC power source 2 and the inverter 5.

In the voltage vector V7, all the positive electrode side switching devices SPu, SPv, SPw of U phase, V phase, and W phase are become ON, all the negative electrode side switching devices SNu, SNv, SNw of U phase, V phase, and W phase are become OFF, and the terminals of the three-phase AC armature windings Cu, Cv, Cw are mutually connected via the positive electrode side electric wire. In this voltage vector V7, current circulates between the three-phase AC armature windings and the inverter, the inverter current Iin becomes zero, and it becomes a state of the zero vector in which current does not flow between the DC power source 2 and the inverter 5.

In other voltage vectors V1 to V6, the inverter current Iin become the armature currents Iu, Iv, Iw which flow through the AC armature windings of U phase, V phase, and W phase. In these voltage vectors V1 to V6, the inverter current Iin does not become zero, and it becomes a state of the effective vector in which current flows between the DC power source 2 and the inverter 5.

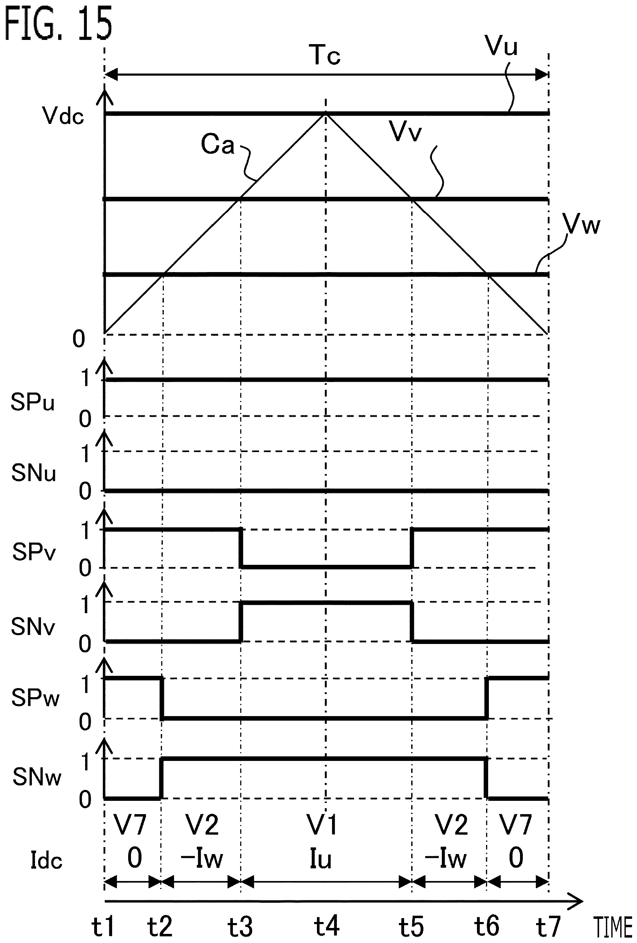

As explained in Embodiment 1, the inverter switching control unit 34 generates the switching signal which turns on and off the switching devices of each phase, by comparing each of three-phase voltage commands Vu, Vv, Vw and the carrier wave Ca. FIG. 15 shows the three-phase voltage commands Vu, Vw, Vw, the carrier wave Ca, and the switching signal of each switching device, in the PWM period Tc. As shown in this figure, in the PWM period Tc, the voltage vectors V0 to V8 are switched. In time t1 to t2 and time t6 to t7, it becomes the voltage vector V7 which is the zero vector. Accordingly, even in the state where the PWM control which applies voltage to the AC armature winding 12 is performed, there is a period of the zero vector in which the inverter current Iin becomes zero in the PWM period, and the converter current Icn can be detected by the bus current Idc in the period of the zero vector.

<Calculation of field current detection value in zero vector>

Then, in the state of the zero vector in which current does not flow between the DC power source 2 and the inverter 5, the current calculation unit 32 detects the bus current detection value in suppling power Idc_det1 and the bus current detection value in circulating Idc_det2. Then, similar to Embodiment 1, the current calculation unit 32 calculates the field current detection value If_det, based on the bus current detection value in suppling power Idc_det1 and the bus current detection value in circulating Idc_det2.

<Calculation of field current detection value in effective vector>

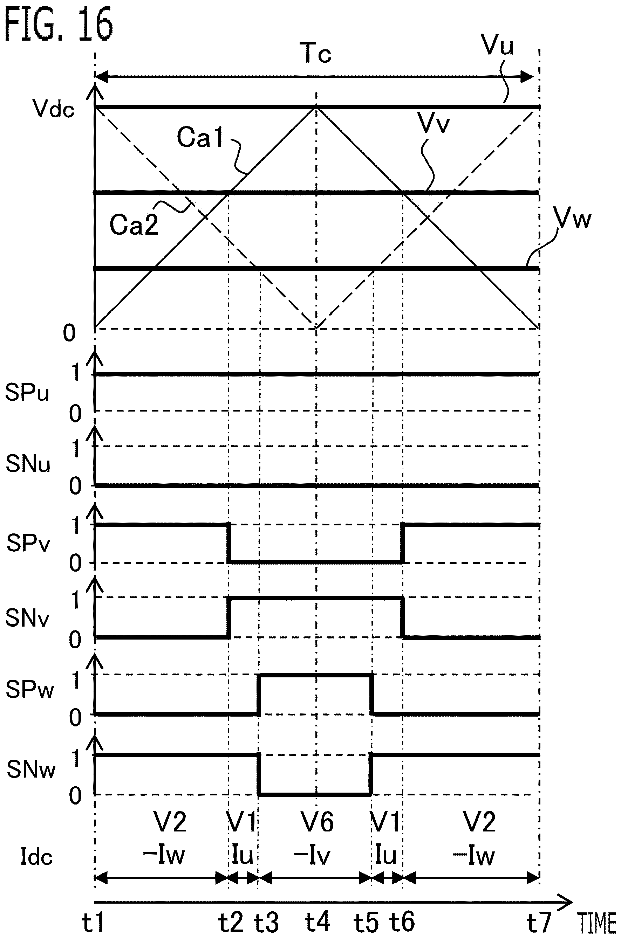

On the other hand, depending on the method of PWM control, there may be no period of the zero vector in the PWM period. FIG. 16 shows an example where there is no zero vector. In this example, the first carrier wave Ca1 is compared with the voltage command Vu of U phase and the voltage command Vv of V phase, and the second carrier wave Ca2 which has a phase opposite to the first carrier wave Ca1 is compared with the voltage command Vw of W phase. As shown in FIG. 16, although there is periods of the voltage vectors V1, V2, V6 which are the effective vectors in the PWM period Tc, there is no period of the voltage vectors V0, V7 which are the zero vectors.

In this case, as shown in FIG. 14, according to each of the voltage vectors V1 to V6 which are the effective vectors, the inverter current Iin becomes equal to any one of the armature currents Iu, Iv, Iw of three phases. For example, in the voltage vector V1, the inverter current Iin becomes equal to the armature current Iu of U phase. In the voltage vector V2, the inverter current Iin becomes equal to the positive/negative reversing value (-Iw) of the armature current Iw of W phase. In this way, even in the effective vector, the inverter current Iin is calculated according to the armature current of specific phase according to the type of effective vector, and the converter current Icn can be extracted by subtracting the inverter current Iin from the bus current Idc.

Then, the current calculation unit 32 detects the armature current based on the output signal of the armature current detection circuit 8, and calculates the bus current detection value in suppling power Idc_det1 and the bus current detection value in circulating Idc_det2 after inverter current removal, based on the bus current detection value Idc_det and the armature current detection value which were detected at the same timing, and the on-off pattern of the switching devices of the inverter 5 at the current detection timing.

The current calculation unit 32 calculates the inverter current detection value Iin_det which is current flowing between the DC power source 2 and the inverter 5, based on the armature current detection value of specific phase which is determined based on the on-off pattern (the voltage vector) of the switching devices of the inverter 5 at the current detection timing. In this determination, the current calculation unit 32 refers to a data table, as show in FIG. 14, in which a relationship among the on-off pattern (the voltage vector) of the switching devices of the inverter 5, the information on the armature current of the specific phase which becomes equal to the inverter current Iin, and the information on the presence or absence of positive/negative reversing of current is preliminarily set. When the on-off pattern (the voltage vector) of the switching devices of the inverter 5 is the zero vector of the voltage vector V0 and V7, the current calculation unit 32 sets the inverter current detection value Iin_det to zero.

The detection timing of armature current may be adjusted with the detection timing of bus current which is the same as Embodiment 1.

Then, the current calculation unit 32 calculates the converter current detection value Icn_det, by subtracting the inverter current detection value Iin_det from the bus current detection value Idc_det which is detected at the same timing as the armature current detection value of the specific phase; and calculates the bus current detection value in suppling power Idc_det1 and the bus current detection value in circulating Idc_det2 after inverter current removal, based on the converter current detection value Icn_det. Specifically, the current calculation unit 32 calculates the converter current detection value Icn_det which is calculated when switching to the power supply path 20, as the bus current detection value in suppling power Idc_det1 after inverter current removal, and calculates the converter current detection value Icn_det which is calculated when switching to the circulation path 21, as the bus current detection value in circulating Idc_det2 after inverter current removal.

Then, similar to Embodiment 1, the current calculation unit 32 calculates the field current detection value If_det, based on the bus current detection value in suppling power Idc_det1 and the bus current detection value in circulating Idc_det2.

For example, when it is the voltage vector V6 at the current detection timing, the current calculation unit 32 determines V phase as the specific phase with reference to the data table as shown in FIG. 14, and sets a positive/negative reversing value (-Iv_det) of the armature current detection value Iv_det of V phase, as the inverter current detection value Iin_det, as shown in the next equation. Then, as shown in the next equation, the current calculation unit 32 calculates the converter current detection value Icn_det, by subtracting the inverter current detection value Iin_det from the bus current detection value Idc_det which is detected at the same timing as the armature current detection value Iv_det of V phase. When switching to the power supply path 20 at the detection timing of the bus current detection value Idc_det, it becomes the converter current detection value in suppling power Icn_det1. And, when switching to the circulation path 21, it becomes the converter current detection value in circulating Icn_det2.

$$Iin\_det=-Iv\_det$$

$$Icn\_det=Idc\_det-Iin\_det \quad ... \ (7)$$

<Short circuit abnormality determination of inverter 5>

If the positive electrode side and the negative electrode side switching devices of the same phase of the inverter 5 become ON at the same time, due to the short circuit abnormality of the switching device of the inverter 5 and the like, the positive electrode side and the negative electrode side of the DC power source 2 are short-circuited, and the excessive inverter current Iin flows. In the present embodiment, since the bus current detection circuit 6 is arranged so that the inverter current Iin can be detected, the excessive inverter current Iin due to the short circuit of the inverter 5 can be detected. Especially, if the armature current detection circuit 8 is arranged between the AC armature winding and the inverter, large current flowing into the bus line cannot be detected directly.

Then, the abnormality determination unit 33 determines that a short circuit abnormality occurred in the inverter 5, when the bus current detection value Idc_det deviates from a normal current range. For example, the abnormality determination unit 33 determines that the short circuit abnormality occurred in the inverter 5, when the bus current detection value Idc_det becomes larger than a preliminarily set short circuit determination value. When determined that the short circuit abnormality occurred in the inverter 5, the inverter switching control unit 34 stops the normal on/off control, and performs on/off control for the short circuit abnormality, such as turning off all the switching devices of the inverter 5.

<Other Embodiments>

Lastly, other embodiments of the present disclosure will be explained. Each of the configurations of embodiments to be explained below is not limited to be separately utilized but can be utilized in combination with the configurations of other embodiments as long as no discrepancy occurs.

(1) In each of the above-mentioned embodiments, there was explained the case where the AC rotary machine 1 is provided with the three-phase AC armature windings. But, the AC rotary machine 1 may be provided with the AC armature windings of plural phases other than three phases, and may be provided with plural sets of the AC armature windings of plural phases.

(2) In each of the above-mentioned embodiments, there was explained the case where the AC rotary machine 1 is the generator motor for vehicle. But, the AC rotary machine 1 may be the AC rotary machine for various kinds of applications other than the generator motor for vehicle.

(3) In each of the above-mentioned embodiments, there was explained the case where the converter 9 is H bridge circuit. But, if the converter switching control unit 31 sets only the voltage vector Vf0 of FIG. 5 when switching to the circulation path 21, since the positive electrode side switching device SP2 of second set always becomes OFF, the circuit part of the positive electrode side switching device SP2 of second set may not be provided, but it may be not connected, or, only an inverse parallel diode may be provided. In this case, since the negative electrode side switching device SN2 of second set always becomes ON, the circuit part of the negative electrode side switching device SN2 of second set may be configured by a connection line.

On the other hand, if the converter switching control unit 31 sets only the voltage vector Vf3 of FIG. 8 when switching to the circulation path 21, since the negative electrode side switching device SN1 of first set always becomes OFF, the circuit part of the negative electrode side switching device SN1 of first set may not be provided, but it may be not connected, or, only an inverse parallel diode may be provided. In this case, since the positive electrode side switching device SP1 of first set always becomes ON, the circuit part of the positive electrode side switching device SP1 of first set may be configured by a connection line.

Although the present disclosure is described above in terms of various exemplary embodiments and implementations, it should be understood that the various features, aspects and functionality described in one or more of the individual embodiments are not limited in their applicability to the particular embodiment with which they are described, but instead can be applied, alone or in various combinations to one or more of the embodiments. It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

REFERENCE SIGNS LIST

1: AC Rotary Machine, 2: DC power Source, 4: Field Winding, 5: Inverter, 6: Bus Current Detection Circuit, 8: Armature Current Detection Circuit, 9: Converter, 11: Controller for AC Rotary Machine, 12: AC Armature Winding, 20: Power Supply Path, 21: Circulation Path, 31: Converter Switching Control Unit, 32: Current Calculation Unit, 33: Abnormality Determination Unit, 34: Inverter Switching Control Unit

**Claims**

1.   A controller for AC rotary machine that controls an AC rotary machine which is provided with an AC armature winding and a field winding, the controller for AC rotary machine comprising:

a converter that is provided with switching devices, and that is provided with a power supply path which supplies current to the field winding from a DC power source and a circulation path which circulates current in the converter and supplies a circulating current to the field winding, which are switched by on and off of the switching devices;
a bus current detection circuit that detects a bus current which is current flowing through a connection path between the DC power source and the converter;
a converter switching control unit that switches the power supply path and the circulation path, by turning on and off the switching devices of the converter; and
a current calculation unit that calculates a field current which is a current flowing into the field winding, based on a bus current in suppling power which is a bus current detected based on an output signal of the bus current detection circuit when switching to the power supply path, and a bus current in circulating which is a bus current detected based on the output signal of the bus current detection circuit when switching to the circulation path.

2.   The controller for AC rotary machine according to claim 1,

wherein the converter is provided with two sets of series circuits in each of which a positive electrode side power semiconductor connected to a positive electrode side of the DC power source and a negative electrode side power semiconductor connected to a negative electrode side of the DC power source are connected in series,
a connection node of the positive electrode side power semiconductor and the negative electrode side power semiconductor of the first set of series circuit is connected to one end of the field winding,
a connection node of the positive electrode side power semiconductor and the negative electrode side power semiconductor of the second set of series circuit is connected to the other end of the field winding, and
at least the positive electrode side power semiconductor of the first set of series circuit and the negative electrode side power semiconductor of the second set of series circuit are switching devices.

3. The controller for AC rotary machine according to claim 2,

wherein the negative electrode side power semiconductor of the first set of series circuit is a switching device, wherein the converter switching control unit, when switching to the power supply path, turns on the positive electrode side switching device of the first set of series circuit, turns off the negative electrode side switching device of the first set of series circuit, and turns on the negative electrode side switching device of the second set of series circuit; and
when switching to the circulation path, turns off the positive electrode side switching device of the first set of series circuit, turns on the negative electrode side switching device of the first set of series circuit, and turns on the negative electrode side switching device of the second set of series circuit.

4. The controller for AC rotary machine according to claim 2,

wherein the positive electrode side power semiconductor of the second set of series circuit is a switching device, wherein the converter switching control unit, when switching to the power supply path, turns on the positive electrode side switching device of the first set of series circuit, turns off the positive electrode side switching device of the second set of series circuit, and turns on the negative electrode side switching device of the second set of series circuit; and
when switching to the circulation path, turns on the positive electrode side switching device of the first set of series circuit, turns on the positive electrode side switching device of the second set of series circuit, and turns off the negative electrode side switching device of the second set of series circuit.

5. The controller for AC rotary machine according to any one of claims 1 to 4,
wherein the current calculation unit calculates the field current by subtracting the bus current in circulating from the bus current in suppling power.

6. The controller for AC rotary machine according to any one of claims 1 to 5,
wherein the current calculation unit performs one or both of a detection which detects the bus current in suppling power by the bus current detection circuit at a center timing of a period when switching to the power supply path, and a detection which detects the bus current in circulating by the bus current detection circuit at a center timing of a period when switching to the circulation path.

7. The controller for AC rotary machine according to any one of claims 1 to 6,
wherein the converter switching control unit performs one or both of a switching which switches to the power supply path during a period longer than a current stable period until current is stabilized, after turning on or off the switching device of the converter, and a switching which switches to the circulation path during a period longer that the current stable period, after turning on or off the switching device of the converter.

8. The controller for AC rotary machine according to any one of claims 1 to 7,
wherein the current calculation unit makes a detection frequency of the bus current in circulating lower than a detection frequency of the bus current in suppling power.

9. The controller for AC rotary machine according to any one of claims 1 to 8, further comprising:

an inverter that is provided with switching devices and performs power conversion between the DC power source and the AC armature winding; and
an inverter switching control unit that turns on and off the switching devices of the inverter, and applies voltage to the AC armature winding,
wherein the bus current detection circuit detects, as the bus current, current which flows through a path which is common between a connection path between the DC power source and the converter and a connection path between the inverter and the DC power source, and
wherein in a state of a zero vector in which current does not flow between the DC power source and the inverter, the current calculation unit detects the bus current in suppling power and the bus current in circulating.

10. The controller for AC rotary machine according to any one of claims 1 to 8, further comprising:

an inverter that is provided with switching devices and performs power conversion between the DC power source and the AC armature winding;

an inverter switching control unit that turns on and off the switching devices of the inverter, and applies voltage to the AC armature winding; and

an armature current detection circuit that detects an armature current which is a current flowing into the AC armature winding,

wherein a bus current detection circuit detects, as the bus current, current which flows through a path which is common between a connection path between the DC power source and the converter and a connection path between the inverter and the DC power source, and

wherein the current calculation unit detects an armature current based on an output signal of the armature current detection circuit, and calculates the bus current in suppling power and the bus current in circulating, based on the bus current and the armature current which were detected at the same timing, and an on-off pattern of the switching devices of the inverter at a current detection timing.

**11.** The controller for AC rotary machine according to claim 10,

wherein the current calculation unit detects the armature current based on the output signal of the armature current detection circuit,

calculates the inverter current which is current flowing between the DC power source and the inverter, based on the armature current of a specific phase which is decided based on the on-off pattern of the switching devices of the inverter at the current detection timing,

calculates the converter current which is current flowing between the DC power source and the converter, by subtracting the inverter current from the bus current which is detected at the same timing as the armature current, and

calculates the bus current in suppling power and the bus current in circulating, based on the converter current.

**12.** The controller for AC rotary machine according to any one of claims 1 to 11, further comprising

an abnormality determination unit that determines an abnormality of the bus current detection circuit,

wherein the abnormality determination unit sets a normal current range in suppling power, based on a ratio of a period switching to the power supply path and a period switching to the circulation path, and

determines that abnormality occurred in the bus current detection circuit, when the bus current in suppling power deviates from the normal current range in suppling power.

**13.** The controller for AC rotary machine according to any one of claims 1 to 12, further comprising

an abnormality determination unit that determines an abnormality of the bus current detection circuit,

wherein the abnormality determination unit determines that abnormality occurred in the bus current detection circuit, when the bus current in circulating deviates from a preliminarily set normal current range in circulating.

**14.** The controller for AC rotary machine according to any one of claims 1 to 13, further comprising

an abnormality determination unit that determines an abnormality of the bus current detection circuit,

wherein the bus current detection circuit is provided with one current detector, and a plurality of signal processors each of which processes an output signal of the current detector and outputs a process signal to the current calculation unit,

wherein the current calculation unit detects a plurality of the bus currents in suppling power, based on process signals of the plurality of signal processors, respectively,

wherein when the plurality of bus currents in suppling power do not coincide mutually, the abnormality determination unit determines that abnormality occurred in the bus current detection circuit.

**15.** The controller for AC rotary machine according to any one of claims 1 to 14, further comprising

an abnormality determination unit that determines an abnormality of the bus current detection circuit,

wherein the bus current detection circuit is provided with one current detector, and a plurality of signal processors each of which processes an output signal of the current detector and outputs a process signal to the current calculation unit,

wherein the current calculation unit detects a plurality of the bus currents in suppling power and a plurality of the bus currents in circulating, based on process signals of the plurality of signal processors, respectively, and calculates a plurality of the field currents, based on the plurality of bus currents in suppling power and the plurality of bus currents in circulating, respectively, and
wherein the abnormality determination unit determines that abnormality occurred in the bus current detection circuit, when the plurality of field currents do not coincide mutually.

16. The controller for AC rotary machine according to any one of claims 1 to 13, further comprising

an abnormality determination unit that determines an abnormality of the bus current detection circuit,
wherein the bus current detection circuit is provided with a plurality of current detectors each of which detects current which flows through each of a plurality of connection path parts provided in parallel between the DC power source and the converter, and a plurality of signal processors each of which processes an output signal of each of the plurality of current detectors and outputs a process signal to the current calculation unit, and whose number is the same as number of the plurality of current detectors,
wherein the current calculation unit calculates a plurality of the bus currents in suppling power, based on process signals of the plurality of signal processors, respectively, and
wherein the abnormality determination unit determines that abnormality occurred in the bus current detection circuit, when a ratio of the plurality of bus currents in suppling power does not coincide with a preliminarily set normal ratio.

17. The controller for AC rotary machine according to any one of claims 1 to 13, further comprising

an abnormality determination unit that determines an abnormality of the bus current detection circuit,
wherein the bus current detection circuit is provided with a plurality of current detectors each of which detects current which flows through each of a plurality of connection path parts provided in parallel between the DC power source and the converter, and a plurality of signal processors each of which processes an output signal of each of the plurality of current detectors and outputs a process signal to the current calculation unit, and whose number is the same as number of the plurality of current detectors,
wherein the current calculation unit detects a plurality of the bus currents in suppling power and a plurality of the bus currents in circulating, based on process signals of the plurality of signal processors, respectively, and calculates a plurality of the field currents, based on the plurality of bus currents in suppling power and the plurality of bus currents in circulating, respectively, and
wherein the abnormality determination unit determines that abnormality occurred in the bus current detection circuit, when a ratio of the plurality of field currents does not coincide with a preliminarily set normal ratio.

18. The controller for AC rotary machine according to any one of claims 1 to 17, wherein the bus current detection circuit uses a non-contact type current sensor.

19. The controller for AC rotary machine according to any one of claims 1 to 18, wherein the AC rotary machine is a generator motor for vehicle .

FIG. 1

EP 4 060 892 A1

19

FIG. 2

# FIG. 3

# FIG. 4

| SP1 | SN1 | SP2 | SN2 | VOLTAGE VECTOR | BUS CURRENT Idc |
|-----|-----|-----|-----|----------------|-----------------|
| 0 | 1 | 0 | 1 | Vf0 | 0 |
| 1 | 0 | 0 | 1 | Vf1 | If1 |
| 0 | 1 | 1 | 0 | Vf2 | −If1 |
| 1 | 0 | 1 | 0 | Vf3 | 0 |

**FIG. 5** <u>Vf0</u>

**FIG. 6** <u>Vf1</u>

FIG. 7   Vf2

9   28   29

SP2

SP1   OFF   ON

If

SN1

ON   SN2

OFF

20

2

Idc   6

FIG. 8   Vf3

9   28   29

SP1

SP2

21   ON   ON

If

SN1   SN2

OFF   OFF

2

Idc   6

# FIG. 9

PWM PERIOD

Vdc — CARRIER WAVE

VOLTAGE COMMAND

PWM SIGNAL

SP1

SN1

SP2

SN2

If

Idc

t1  t2  t3  t4  t5  TIME

Vf0  Vf1  Vf0

FIG. 10

# FIG. 11

# FIG. 12

# FIG. 13

## FIG. 14

| SPu | SNu | SPv | SNv | SPw | SNw | VOLTAGE VECTOR | INVERTER CURRENT Iin |
|-----|-----|-----|-----|-----|-----|----------------|----------------------|
| 0 | 1 | 0 | 1 | 0 | 1 | V0 | 0 |
| 1 | 0 | 0 | 1 | 0 | 1 | V1 | Iu1 |
| 1 | 0 | 1 | 0 | 0 | 1 | V2 | $-$Iw1 |
| 0 | 1 | 1 | 0 | 0 | 1 | V3 | Iv1 |
| 0 | 1 | 1 | 0 | 1 | 0 | V4 | $-$Iu1 |
| 0 | 1 | 0 | 1 | 1 | 0 | V5 | Iw1 |
| 1 | 0 | 0 | 1 | 1 | 0 | V6 | $-$Iv1 |
| 1 | 0 | 1 | 0 | 1 | 0 | V7 | 0 |

EP 4 060 892 A1

# FIG. 15

FIG. 16

## INTERNATIONAL SEARCH REPORT

| International application No. |
|---|
| PCT/JP2019/044232 |

**A. CLASSIFICATION OF SUBJECT MATTER**
Int. Cl. H02P25/03(2016.01)i
FI: H02P25/03

According to International Patent Classification (IPC) or to both national classification and IPC

**B. FIELDS SEARCHED**

Minimum documentation searched (classification system followed by classification symbols)
Int. Cl. H02P25/03

Documentation searched other than minimum documentation to the extent that such documents are included in the fields searched
Published examined utility model applications of Japan     1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2019-22384 A (DENSO CORP.) 07 February 2019, | 1-7, 13, 18-19 |
| A | paragraphs [0030]-[0033], [0042], [0100], fig. 1, 9 | 8-12, 14-17 |
| Y | KR 10-2011-0087454 A (HALLA HOLDINGS CORPORATION) | 1-7, 13, 18-19 |
| A | 03 August 2011, paragraphs [0011]-[0022], fig. 1-3 | 8-12, 14-17 |
| Y | JP 2018-98872 A (DENSO CORP.) 21 June 2018, paragraphs [0032]-[0042], [0050]-[0054], fig. 1, 2 | 2-7, 13, 18-19 |
| Y | JP 2019-80455 A (MITSUBA CORP.) 23 May 2019, paragraph [0054], fig. 2 | 18-19 |

☒ Further documents are listed in the continuation of Box C.     ☒ See patent family annex.

| | | |
|---|---|---|
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
|---|---|
| 20.01.2020 | 28.01.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2019/044232 |

C (Continuation).　　DOCUMENTS CONSIDERED TO BE RELEVANT

| Category* | Citation of document, with indication, where appropriate, of the relevant passages | Relevant to claim No. |
| --- | --- | --- |
| A | JP 2019-164081 A (DENSO CORP.) 26 September 2019, paragraphs [0090]-[0123], fig. 1-7 | 1-19 |
| A | JP 2018-21702 A (SHARP CORP.) 08 February 2018, paragraph [0015], fig. 3 | 1-19 |

Form PCT/ISA/210 (continuation of second sheet) (January 2015)

**INTERNATIONAL SEARCH REPORT**
Information on patent family members

International application No.

PCT/JP2019/044232

| Patent Documents referred to in the Report | Publication Date | Patent Family | Publication Date |
|---|---|---|---|
| JP 2019-22384 A | 07.02.2019 | (Family: none) | |
| KR 10-2011-0087454 A | 03.08.2011 | (Family: none) | |
| JP 2018-98872 A | 21.06.2018 | (Family: none) | |
| JP 2019-80455 A | 23.05.2019 | (Family: none) | |
| JP 2019-164081 A | 26.09.2019 | (Family: none) | |
| JP 2018-21702 A | 08.02.2018 | (Family: none) | |

Form PCT/ISA/210 (patent family annex) (January 2015)

**EP 4 060 892 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018182798 A

- JP 4382768 B